Europäisches Patentamt

European Patent Office

Office européen des brevets

(19)

(11) Numéro de publication : **0 589 797 A1**

## (12) DEMANDE DE BREVET EUROPEEN

(21) Numéro de dépôt : 93402333.4

(22) Date de dépôt : 24.09.93

(51) Int. Cl.$^5$ : **H02H 3/04,** H01H 47/00, G01R 31/02, H03K 17/18, G01R 31/00

(30) Priorité : 25.09.92 FR 9211477

(43) Date de publication de la demande :
30.03.94 Bulletin 94/13

(84) Etats contractants désignés :
DE ES GB IT

(71) Demandeur : VALEO ELECTRONIQUE
2 rue Fernand Pouillon
F-94000 Creteil (FR)

(72) Inventeur : **Casnabet, Bertrand**
**36 rue d'Hauteville**
**F-75010 Paris (FR)**
Inventeur : **Nicolai, Jean-Marc**
**3 rue Joseph Rivière**
**F-92400 Courbevoie (FR)**

(74) Mandataire : **Gamonal, Didier et al**
**Valeo Management Services Sce Propriété**
**Industrielle 2, rue André Boulle B.P. 150**
**F-94004 Créteil (FR)**

(54) **Système de commutation autotestable.**

(57)    La présente invention concerne un système de commutation autotestable.

Elle concerne le domaine de l'alimentation électrique de sécurité de charges électriques demandant une fonction de test comme un embrayage électromagnétique.

Selon l'invention, on dispose deux résistances (Z1, Z2) aux points (T1, T2) d'alimentation de la charge électrique (L). La mesure des tensions aux points (T1, T2) permet de détecter d'éventuelles situations de courts-circuits ou de coupe-circuits sur les interrupteurs commandés (I1, I2).

Application au test de systèmes embarqués.

FIG.1

EP 0 589 797 A1

La présente invention concerne un système de commutation autotestable.

Elle concerne le domaine de l'alimentation électrique de sécurité de charges électriques demandant une fonction de test comme un embrayage électromagnétique, un moteur électrique, etc.

On sait commander l'alimentation électrique d'une charge électrique entre deux potentiels au moyen d'un système de commutation.

En particulier, si la charge électrique est constituée par un embrayage électromagnétique, la charge électrique est constituée par au moins un électro-aimant qui mobilise une partie mobile sous l'action des forces électromagnétiques engendrées.

Une telle charge électrique est soumise à des actions demandées par un circuit de commande et son alimentation doit être testée de façon à renseigner le circuit de commande sur l'état de fonctionnement du système de commutation qui le mettra en fonction.

Un tel système de commutation comporte deux interrupteurs.

Un premier interrupteur est connecté entre un premier potentiel électrique d'une source électrique et une première borne de la charge alimentée.

Un second interrupteur est connecté entre un second potentiel électrique d'une source électrique et une seconde borne de la charge alimentée.

Quand les deux interrupteurs sont en ordre de marche, la charge est réellement alimentée seulement si les deux interrupteurs sont commandés dans l'état fermé (ou conducteur).

Un objet de l'invention est de produire un moyen de tester l'état de marche des interrupteurs de façon à renseigner le circuit de commande de l'alimentation de la charge sur l'état éventuellement défaillant de l'un des interrupteurs.

En effet, que l'interrupteur soit du type électromagnétique (relais à électro-aimant) ou statique (transistor de commutation), l'un des états défaillants les plus dangereux est le court circuit de l'interrupteur.

C'est un avantage de l'invention de permettre de renseigner directement le circuit de commande de l'apparition d'un tel état.

C'est un autre objet de l'invention de détecter si la charge électrique est accidentellement ou temporairement devenue un circuit ouvert ou un court-circuit.

Dans le cas où la charge est un moteur électrique, dont l'alimentation est commandée par un circuit basé sur une pluralité d'interrupteurs au moins pour partie, un circuit de contrôle détermine, en fonction de divers paramètres d'entrée, l'ordre d'alimentation.

Cependant le moteur électrique peut être déconnecté de sa ligne d'alimentation, ou un composant du moteur comme l'ensemble collecteur-balais peut être cassé. Le moteur électrique est alors équivalent à un circuit ouvert et il faut pouvoir le détecter rapidement pour remédier à la situation et éviter que d'autres actions soient commandées comme si le moteur électrique était fonctionnel.

Dans un autre genre de pannes, la charge peut être un court-circuit si le moteur électrique a grillé par fusion de l'induit. On a le même besoin, résolu par l'invention.

En effet, l'invention concerne un système de commutation autotestable, l'alimentation électrique d'une charge électrique étant prise entre deux potentiels au moyen d'au moins deux interrupteurs, un premier interrupteur étant connecté entre un premier potentiel électrique d'une source électrique et une première borne de la charge alimentée, un second interrupteur étant connecté entre un second potentiel électrique d'une source électrique et une seconde borne de la charge alimentée.

L'invention se caractérise en ce que le système comporte aussi deux impédances de valeurs plus élevées que celle de la charge alimentée, une première impédance étant connectée entre le point commun entre le premier interrupteur et la charge et un troisième potentiel, la seconde impédance étant connectée entre le point commun entre le second interrupteur et la charge et un quatrième potentiel, au moins l'un des points communs étant connecté à un circuit de mesure de tension dont la sortie est connectée à un circuit de test qui produit en réponse un signal de défaillance.

D'autres caractéristiques et avantages apparaîtront plus nettement à l'aide de la description et des figures qui sont :
- la figure 1 : un schéma d'un mode de réalisation du système de commutation selon l'invention ;
- les figures 2 à 6 : des schémas indiquant les divers états du système ;
- la figure 7 : un tableau de codage de test ;
- la figure 8 : un schéma d'un mode de réalisation d'un circuit de test associé au système de commutation de l'invention ;
- la figure 9 : un schéma d'un autre mode de réalisation d'un système de commutation autotestable selon l'invention ;
- la figure 10 : un tableau de codage de test ;
- la figure 11 : un autre tableau de codage de test.

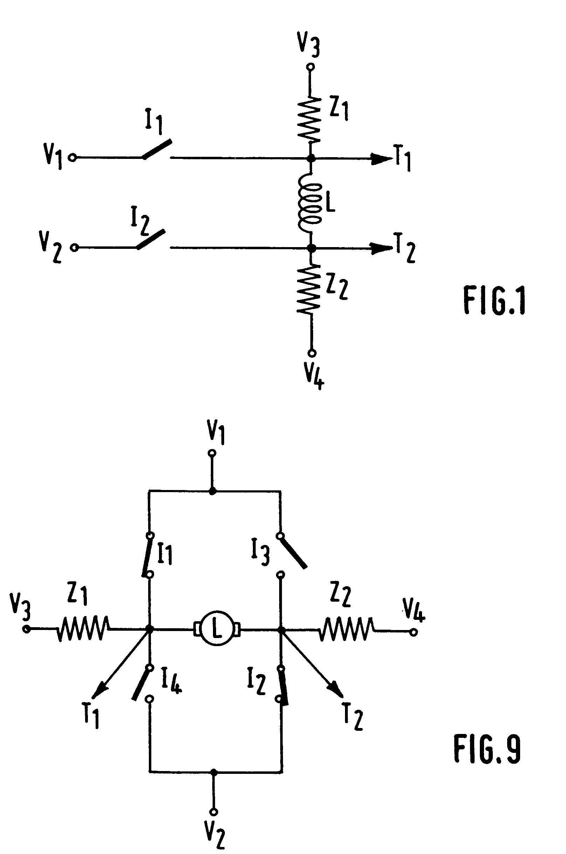

A la figure 1, le système de commutation comporte une première borne connectée à un potentiel V1, comme la tension délivrée en sortie de l'antivol d'un véhicule. Cette première borne est connectée à une première borne d'un premier interrupteur I1, dont la seconde borne est connectée à une première borne d'une charge électrique.

La charge L peut être constituée par l'induit d'un moteur électrique, par le bobinage d'un embrayage électromagnétique, notamment destiné à une direction assistée électrique, ou toutes autres charges comme par exemple une lampe à décharge, aux bornes d'un secondaire d'un transformateur haute tension.

L'autre borne de la charge est connectée à une seconde borne d'un second interrupteur I2 dont la première borne est connectée à une seconde borne d'alimentation du système de commutation connectée à un potentiel V2 comme la masse électrique d'un véhicule.

Le point commun T1, entre la seconde borne de l'interrupteur I1 et la première borne de la charge L, est connecté à une première borne d'une impédance Z1 dont la seconde borne est connectée à un potentiel V3 comme la masse électrique du véhicule.

Le point commun T2, entre la seconde borne de l'interrupteur I2 et la seconde borne de la charge L, est connecté à une première borne d'une impédance Z2 dont la seconde borne est connectée à un potentiel V4 comme la tension continue fournie par le régulateur électronique embarqué à bord du véhicule.

Selon l'invention, en choisissant dans un mode de réalisation préféré des impédances Z1 et Z2, résistives et de valeurs égales supérieures notablement à la valeur de l'impédance de la charge L, il est possible, par mesure de tensions électriques, de détecter si un interrupteur I1 ou I2 est en court-circuit ou en circuit ouvert accidentel. A cet effet, les points communs T1 et T2 sont connectés à un circuit générateur d'un signal de défaillance produit grâce au test décrit ci-dessous.

Dans un mode de fonctionnement normal, si la charge L doit être alimentée, les interrupteurs I1 et I2 reçoivent chacun une commande de fermeture (ou de mise en conduction). Du fait que Z1 et Z2 sont d'impédances élevées, la charge voit la différence de tension V1 - V2 habituelle pour la faire fonctionner.

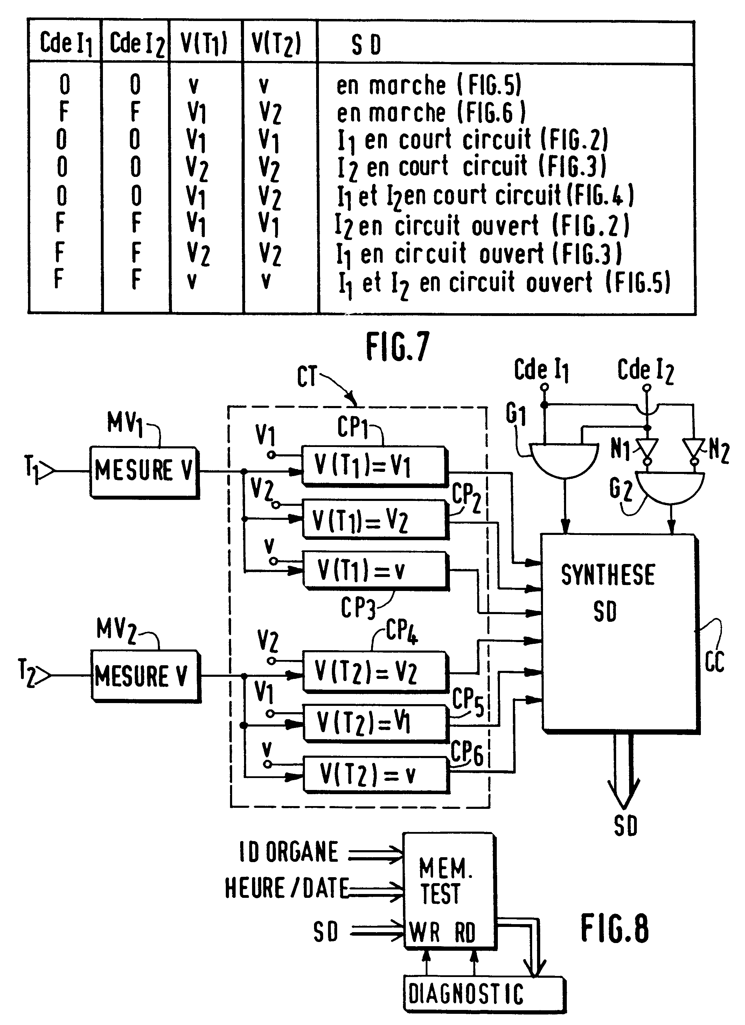

Dans cette configuration, le circuit est équivalent au schéma de la figure 6, dans lequel on voit que la tension V(T1) = V1 et la tension V(T2) = V2. Le circuit générateur du signal de défaillance synthétise un signal de défaillance SD inactif c'est-à-dire portant l'information que les interrupteurs sont en état de marche.

Quand la charge L doit être désactivée, les interrupteurs I1 et I2 reçoivent une commande d'ouverture (ou de blocage) et se trouvent dans la situation représentée à la figure 1. Le schéma équivalent est représenté à la figure 5, dans l aquelle on constate que la tension V(T1) et la tension V(T2) sont égales à une tension v dépendant des impédances Z1 et Z2 et des tensions V3 et V4. Cependant les deux bornes de la charge L étant au même potentiel, celle-ci est inactive.

Pour limiter les courants notamment, il est souhaitable alors que le troisième potentiel V3 soit de valeur aussi proche que possible du paramètre potentiel V4, c'est-à-dire aussi petit que possible.

Cependant, en particulier quand les interrupteurs I1 et I2 sont constitués par des transistors à effet de champ, il existe un risque que l'un des interrupteurs soit défaillant ou bien par court-circuit ou bien par claquage dans lequel l'interrupteur est équivalent à un circuit ouvert.

A la figure 7, on a représenté un tableau permettant de coder un signal SD de défaillance possible. Les deux premières colonnes du tableau représentent les états ouverts O ou fermés F des interrupteurs provoqués par respectivement une commande Cde I1 et une commande Cde I2. Les deux colonnes suivantes représentent les valeurs mesurées V(T1) et V(T2) par un circuit de mesure de tension intégré au circuit générateur de signal de défaillance SD. La dernière colonne SD indique l'information associée au signal SD.

Les deux premières lignes du tableau ont déjà été décrites ci-dessus et présentent une information "en marche" pour les interrupteurs I1 et I2.

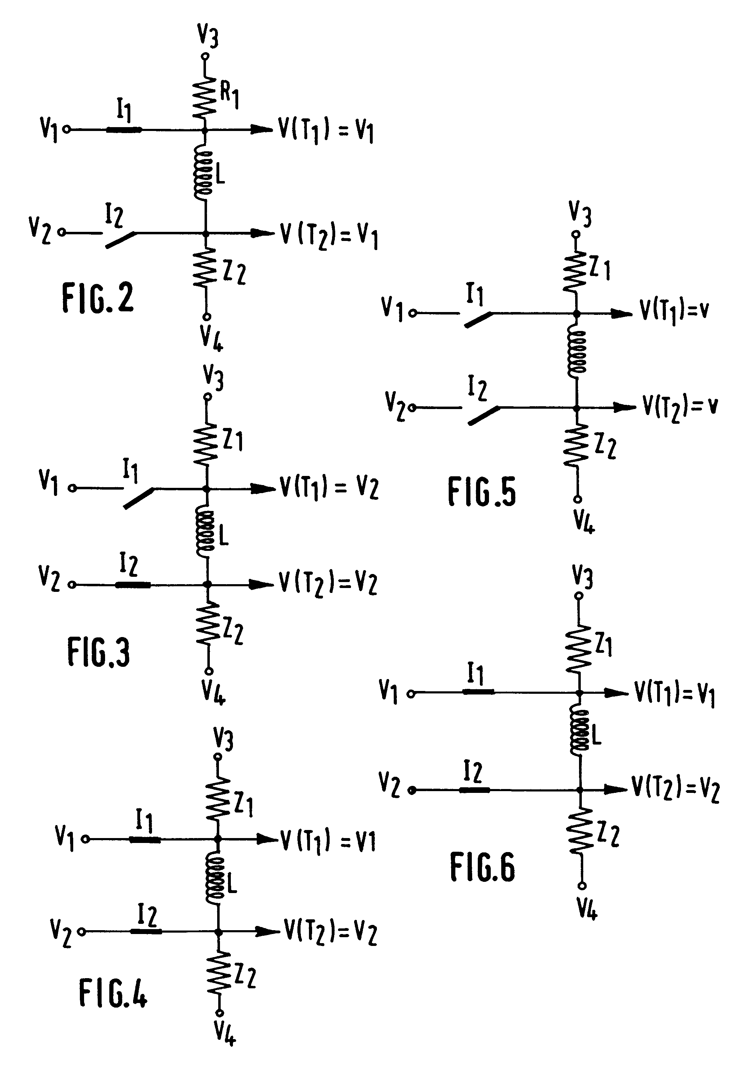

La troisième ligne du tableau de la figure 7 correspond à une situation où l'interrupteur 11 est en court-circuit alors que les commandes des interrupteurs I1 et I2 étant destinés à le maintenir ouvert. La détection de la valeur des commandes de I1 et I2 à la valeur ouverte "O", et la détection que V(T1) = V(T2) = V1 indiquent que l'interrupteur I1 est en court-circuit fautif. La situation est représentée dans le schéma équivalent de la figure 2.

Dans la quatrième ligne du tableau de la figure 7, on a été représenté la situation similaire, schématisée à la figure 3, dans laquelle l'interrupteur I2 est en court-circuit. Les tensions V(T1) et V(T2) sont alors égales à la valeur V2.

Dans la cinquième ligne du tableau de la figure 7, on a représenté la situation schématisée à la figure 4 dans laquelle les deux interrupteurs I1 et I2 sont en courts-circuits. Les tensions V(T1) et V(T2) correspondent au cas où les deux commandes Cde I1 et Cde I2 devaient être à l'état fermé.

Les trois lignes suivantes du tableau de la figure 7 correspondent aux cas analogues dans lesquels les commandes Cde I1 et Cde I2 sont à l'état fermé "F" et dans lesquels les interrupteurs I1 et/ou I2 correspondent à des cas de défaillance en circuit ouvert.

Cependant, l'état des interrupteurs peut ne pas changer en même temps. Chaque interrupteur peut être commandé en fermeture à son tour. Dans ces cas, on se trouve dans les situations des circuits des figures 2 et 3. Ils sont détectables de la même façon et sont aussi protégés par la présente demande.

A la figure 8, on a représenté un circuit générateur d'un signal de défaillance SD dans un mode de réalisation de l'invention.

Le circuit de la figure 8 comporte une première borne connectée au point commun T1 du système de commutation de la figure 1. Il comporte aussi une seconde borne connectée au point commun T2 du système de commutation de la figure 1. Chacune de ces bornes est connectée à l'entrée respective d'un circuit MV1 et MV2 de mesure de tension. La sortie est connectée à une première entrée de trois comparateurs CP1,CP2,CP3 dont la deuxième entrée est respectivement connectée à des potentiels V1,V2 et v.

La sortie du circuit de mesure MV2 est connectée à une première entrée de trois comparateurs CP4,CP5 et CP6 dont une seconde borne est respectivement connectée à des potentiels V2, V1 et v.

Les six comparateurs CP1 à CP6 constituent un mode de réalisation d'un circuit de test CT.

En particulier, les comparateurs CP1-CP3 et CP4-CP6 permettent de détecter qu'au moins un terme d'une condition de défaillance, terme associé à chaque comparateur, est vérifié. Dans le cas du comparateur CP1, le terme associé est exprimé par le test suivant :

$$V(T1) = V1 ?$$

Une condition de défaillance est par exemple vérifiée quand les sorties des comparateurs CP1 et CP5 (situation notamment représentée à la ligne 3 du tableau de la figure 7) sont hautes (ou actives). Le circuit de codage CC testera donc, si la sortie de G1 est haute (ou active) et si les sorties de CP1 et CP5 sont hautes aussi pour produire un signal de défaillance SD (par exemple le code binaire "101").

Les sorties des comparateurs CP1 à CP6 sont connectées à des entrées respectives d'un circuit de codage CC d'un signal de défaillance SD. Le circuit générateur du signal de défaillance SD comporte aussi deux bornes recevant l'information de commande des interrupteurs, respectivement Cde I1 et Cde I2. Ces deux bornes sont connectées à une porte ET G1 dont la sortie est connectée à une entrée du circuit de codage CC de façon à l'informer de l'état fermé (respectivement ouvert selon le codage) des interrupteurs. Ces deux bornes sont aussi connectées par l'intermédiaire de deux inverseurs N1 et N2 dont les sorties sont connectées aux entrées d'une seconde porte ET G2 de façon à l'informer de l'état ouvert (respectivement fermé selon le codage) des interrupteurs.

Le circuit de codage CC produit un signal de sortie SD par exemple sur trois bits représentant l'information de test du système de commutation.

On n'a pas représenté les valeurs de codage qui restent arbitraires.

Dans un mode de réalisation le signal de défaillance SD est transmis au port d'entrée d'écriture d'une mémoire enregistrant diverses défaillances. A cet effet, la mémoire enregistre aussi l'identification de l'organe défaillant (ici le système de commutation) ID ORGANE et l'heure et la date. La mémoire des codes de défaillance peut être connectée à un dispositif de diagnostic qui permet à un technicien de maintenance de lire son contenu et d'interpréter ainsi la défaillance.

Le concept de l'invention permet de nombreuses adaptations. En particulier, on a représenté une application à un système de commutation comportant quatre interrupteurs montés en pont dit pont en H.

La moitié supérieure du pont comporte une connexion à une tension V1, transmise aux premières bornes de deux interrupteurs I1 et I3, dont les secondes bornes sont connectées à des points communs T1 et T2. La charge L est connectée entre les points T1 et T2. De même, le pont comporte une moitié inférieure connectée à une tension V2 transmise à des premières bornes de deux interrupteurs I4 et I2 dont les secondes bornes sont connectées aux points communs T1 et T2. On dispose en série avec les points T1 et T2, une connexion à un potentiel V3, et une impédance Z1 sur le point T1, une connexion à un potentiel V4, et une impédance Z2 sur le point T2.

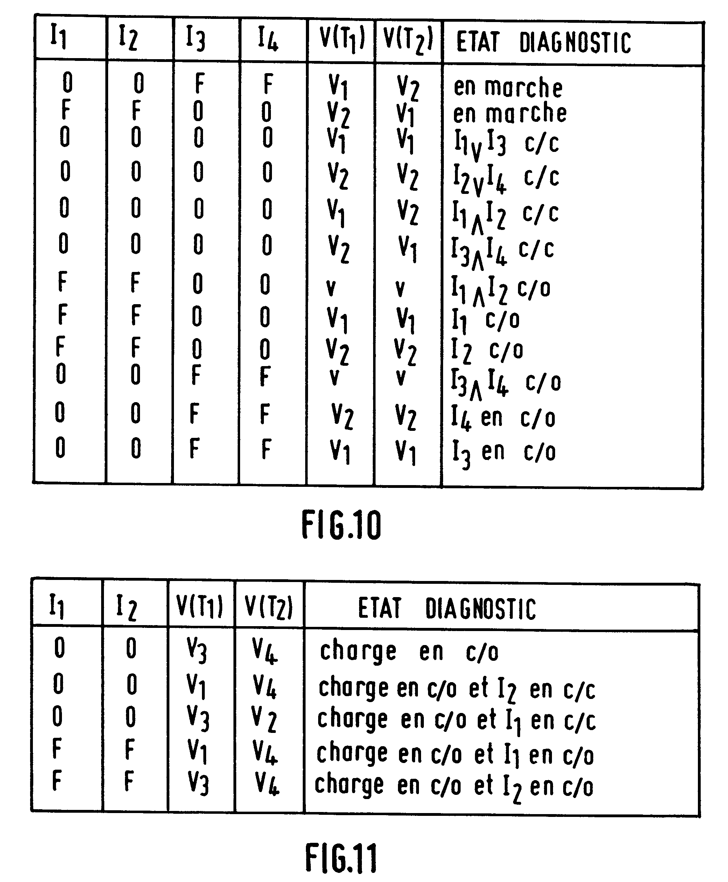

Dans l'application représentée à la figure 9, les interrupteurs I1 et I2 sont fermés, la charge L étant alimentée dans un premier sens. Quand ce sont les interrupteurs I1 et I4 qui sont alimentés, la charge L est alimentée dans un second sens. C'est en particulier le cas d'un moteur d'essuyage.

A la figure 10, on a représenté un tableau analogue au tableau de la figure 7 mais dans lequel quatre colonnes sont réservées aux commandes de chacun des interrupteurs I1 à I4. Les deux premières lignes du tableau de la figure 10 correspondent à un état de marche convenable. Les quatre lignes suivantes correspondent respectivement aux cas où les interrupteurs I1 ou I3, I2 ou I4, I1 et I2, et I3 et I4 sont en courts-circuits c/c.

Les six lignes suivantes correspondent aux cas où les interrupteurs I1 et I2, I1, I2, I3 et I4, I4, et I3 sont en courts-circuits c/o.

On dispose ainsi aussi d'un moyen de test automatique de l'état des interrupteurs du pont en H. La réalisation du circuit générateur du signal de défaillance SD, qui indique un diagnostic du système de commutation, est analogue à celle du circuit de la figure 8 et ne sera pas détaillée ici.

Le circuit générateur du signal de défaillance peut être réalisé sous forme d'un circuit intégré, ou bien en logique combinatoire, ou bien en logique microprogrammée. Il peut aussi constituer une partie des ressources de traitement d'un calculateur embarqué, notamment constitué autour d'au moins un microcontrôleur.

Le système de commutation s'applique avantageusement dans un dispositif de direction assistée électrique, notamment pour l'alimentation d'un embrayage électromagnétique disposé entre un moteur électrique portant un arbre menant relié à l'entrée de l'embrayage, et un réducteur portant un arbre mené relié à la sortie de l'embrayage. Le signal de défaillance SD est alors communiqué au calculateur de pilotage de la direction assistée et, éventuellement, à un système de diagnostic électronique, détenu par le réparateur du véhicule.

L'invention permet donc une maintenance plus efficace et une surveillance plus précise que les systèmes de l'art antérieur.

Les interrupteurs peuvent être autodéclenchables ou commandables par des commandes externes. Dans le premier cas, le déclenchement de l'interrupteur est provoqué par un phénomène physique, comme le dépassement d'un seuil de tension, ou d'une température. Le circuit générateur du signal de défaillance reçoit alors l'information de déclenchement Cde I1, Cde I2 ; sous forme d'un signal de détection du déclenchement de l'interrupteur ou de tout autre phénomène qui lui est lié, comme par exemple le facteur déclenchant (seuil de tension, de température, etc.). Le système de commutation est alors associé à un organe détecteur de ce déclenchement.

Dans le second cas, la commutation est demandée par un organe maître, sous forme par exemple d'un signal logique issu d'un calculateur, qui est alors directement connecté à l'entrée correspondante Cde I1 ou Cde I2.

Le concept de l'invention s'applique à un système de commutation au sens élargi. En particulier, dans une large mesure, le système de l'invention permet de travailler à des fréquences de commutation élevées, par exemple dans le cas d'un onduleur ou d'un cycloconvertisseur d'alimentation d'une charge.

Les tensions V1 à V4 peuvent être continues, variables ou périodiques.

Le système de commutation autotestable de l'invention est aussi capable de produire une information sur l'état de la charge électrique L. En effet, en se plaçant dans un état où les interrupteurs I1 et I2 sont ouverts, si la charge L est équivalente à un circuit ouvert, les tensions mesurées V(T1) et V(T2) seront respectivement égales aux tensions V3 et V4.

Si la charge est équivalente à un court-circuit, la tension en T1 ou T2 est identique et présente une valeur plus élevée que celle du cas où la charge est présente et pas en court-circuit.

De même le système de commutation permet de tester la combinaison du court-circuit ou du circuit ouvert de l'un des interrupteurs et de la charge. En effet, si l'interrupteur I1 et la charge sont en circuit ouvert accidentels on mesure V(T1) = V3 et V(T2) = V2.

Si par contre, I1 est en court-circuit accidentel et que la charge est en circuit ouvert accidentel et que la charge est en circuit ouvert accidentel on mesure V(T1) = V1 et V(T2) = V4. Ces combinaisons sont résumées dans le tableau de la figure 11.

La logique permettant de coder ces divers états est facilement réalisable en adaptant le modèle présenté à la figure 8.

## Revendications

1.  Système de commutation autotestable, le système de commutation comportant au moins deux interrupteurs à travers lesquels une charge électrique est alimentée, un premier interrupteur étant connecté entre un premier potentiel électrique d'une source électrique et une première borne de la charge alimentée, un second interrupteur étant connecté entre un second potentiel électrique d'une source électrique et une seconde borne de la charge alimentée, caractérisé en ce que le système comporte aussi deux impédances (Z1, Z2) de valeurs plus élevées que celle de la charge alimentée (L), une première impédance (Z1) étant connectée entre un troisième potentiel (V3) et le point commun (T1) entre le premier interrupteur (I1) et la charge (L), la seconde impédance (Z2) étant connectée entre un quatrième potentiel (V4) et le point commun (T2) entre le second interrupteur (I2) et la charge (L), au moins l'un des points communs (T1, T2) étant connecté à un circuit générateur d'un signal de défaillance comportant au moins un circuit (MV) de mesure de tension dont la sortie est connectée à un circuit (CT) de test dont la sortie est connectée à l'entrée d'un circuit de codage (CC) qui produit en réponse un signal de défaillance (SD).

2.  Système selon la revendication 1, caractérisé en ce que que les impédances de test (Z1, Z2) sont des résistances de valeurs supérieures à la résistance de la charge (L).

3.  Système selon la revendication 1, caractérisé en ce que les deux impédances de test (Z1, Z2) sont de mêmes valeurs.

4.  Système selon la revendication 1, caractérisé en ce que le troisième potentiel (V3) est inférieur au quatrième potentiel (V4), si le premier potentiel (V1) est supérieur au deuxième potentiel (V2), ou inversement.

5.  Système selon la revendication 4, caractérisé en ce que les second et troisième potentiels (V2, V3) sont égaux, notamment à la masse électrique.

6.  Système selon les revendications 4 ou 5, caractérisé en ce que le troisième potentiel (V3) est de valeur aussi petite que possible.

7.  Système selon la revendication 1, caractérisé en ce que le circuit de test (CT) comporte une série de comparateurs (CP1-CP3, CP4-CP6) dont une première entrée est connectée à la sortie d'un circuit de mesure (MV1,MV2) d'une tension (V(T1), V(T2)) aux points communs (T1,T2), et dont une seconde entrée est connectée à un potentiel (V1-V4,v) de référence, correspondant à un terme d'une condition de défaillance, la sortie de l'un ou l'autre des comparateurs (CP1-CP6) étant active quand le terme associé de la condition de défaillance est vérifié.

8. Système selon la revendication 7, caractérisé en ce que le circuit de codage (cc) reçoit aussi une information de l'état fermé ou ouvert de la commande des interrupteurs (I1,I2) produite par un circuit (G1,N1,N2,G2) connecté à des bornes de réception d'un signal de déclenchement (Cde I1, Cde I2).

9. Système selon la revendication 8, caractérisé en ce que le circuit générateur du signal de défaillance est connecté à une mémoire des codes de défaillance connectable à un dispositif de diagnostic.

10. Système selon l'une des revendications précédentes, caractérisé en ce qu'il comporte quatre interrupteurs (I1-I4) montés en pont en H sur la charge (L), les première et seconde impédances (Z1,Z2) étant connectées respectivement entre un point commun (T1,T2) et une tension (V3,V4).

11. Application au test d'un système de commutation pour un embrayage électromagnétique, notamment destiné à être disposé dans un dispositif de direction assistée de véhicule.

12. Application au test d'un système de commutation pour un moteur électrique, notamment destiné à équiper un dispositif d'essuyage de vitres de véhicule.

EP 0 589 797 A1

FIG.1

FIG.9

7

FIG.2

FIG.3

FIG.4

FIG.5

FIG.6

| Cde I$_1$ | Cde I$_2$ | V(T$_1$) | V(T$_2$) | S D |
|-----------|-----------|----------|----------|-----|
| 0 | 0 | v | v | en marche (FIG.5) |
| F | F | V$_1$ | V$_2$ | en marche (FIG.6) |
| 0 | 0 | V$_1$ | V$_1$ | I$_1$ en court circuit (FIG.2) |
| 0 | 0 | V$_2$ | V$_2$ | I$_2$ en court circuit (FIG.3) |
| 0 | 0 | V$_1$ | V$_2$ | I$_1$ et I$_2$ en court circuit (FIG.4) |
| F | F | V$_1$ | V$_1$ | I$_2$ en circuit ouvert (FIG.2) |
| F | F | V$_2$ | V$_2$ | I$_1$ en circuit ouvert (FIG.3) |
| F | F | v | v | I$_1$ et I$_2$ en circuit ouvert (FIG.5) |

## FIG.7

FIG.8

| $I_1$ | $I_2$ | $I_3$ | $I_4$ | $V(T_1)$ | $V(T_2)$ | ETAT DIAGNOSTIC |
|---|---|---|---|---|---|---|
| 0 | 0 | F | F | $V_1$ | $V_2$ | en marche |
| F | F | 0 | 0 | $V_2$ | $V_1$ | en marche |
| 0 | 0 | 0 | 0 | $V_1$ | $V_1$ | $I_1 \vee I_3$ c/c |
| 0 | 0 | 0 | 0 | $V_2$ | $V_2$ | $I_2 \vee I_4$ c/c |
| 0 | 0 | 0 | 0 | $V_1$ | $V_2$ | $I_1 \wedge I_2$ c/c |
| 0 | 0 | 0 | 0 | $V_2$ | $V_1$ | $I_3 \wedge I_4$ c/c |
| F | F | 0 | 0 | v | v | $I_1 \wedge I_2$ c/o |
| F | F | 0 | 0 | $V_1$ | $V_1$ | $I_1$ c/o |
| F | F | 0 | 0 | $V_2$ | $V_2$ | $I_2$ c/o |
| 0 | 0 | F | F | v | v | $I_3 \wedge I_4$ c/o |
| 0 | 0 | F | F | $V_2$ | $V_2$ | $I_4$ en c/o |
| 0 | 0 | F | F | $V_1$ | $V_1$ | $I_3$ en c/o |

## FIG.10

| $I_1$ | $I_2$ | $V(T_1)$ | $V(T_2)$ | ETAT DIAGNOSTIC |
|---|---|---|---|---|
| 0 | 0 | $V_3$ | $V_4$ | charge en c/o |
| 0 | 0 | $V_1$ | $V_4$ | charge en c/o et $I_2$ en c/c |
| 0 | 0 | $V_3$ | $V_2$ | charge en c/o et $I_1$ en c/c |
| F | F | $V_1$ | $V_4$ | charge en c/o et $I_1$ en c/o |
| F | F | $V_3$ | $V_4$ | charge en c/o et $I_2$ en c/o |

## FIG.11

Office européen
des brevets

# RAPPORT DE RECHERCHE EUROPEENNE

Numero de la demande

EP 93 40 2333

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| A | DE-A-39 28 225 (ALPS ELECTRIC) <br> * abrégé; figures 2,3,5,7 * <br> --- | 1,7-9 | H02H3/04 <br> H01H47/00 <br> G01R31/02 <br> H03K17/18 <br> G01R31/00 |
| A | DE-U-91 07 193 (BOSCH-SIEMENS HAUSGERÄTE) <br> * page 4, alinéa 1 -alinéa 2; figures 1,2 * <br> --- | 1,5,12 | |
| A | EP-A-0 055 816 (IBM) <br> * page 4, alinéa 4; figures 1,3 * <br> ----- | 1,8,10 | |

| DOMAINES TECHNIQUES RECHERCHES (Int.Cl.5) |
|---|
| H02H <br> H01H <br> G01R <br> H03K |

Le présent rapport a été établi pour toutes les revendications

| Lieu de la recherche | Date d'achèvement de la recherche | Examinateur |
|---|---|---|
| LA HAYE | 22 Décembre 1993 | Iwansson, K |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
.....................................................................
& : membre de la même famille, document correspondant

EPO FORM 1503 03.82 (P04C02)